Europäisches Patentamt

European Patent Office

Office européen des brevets

(11) Publication number: **0 459 439 A2**

# EUROPEAN PATENT APPLICATION

(21) Application number: 91108785.6

(22) Date of filing: 29.05.91

(51) Int. Cl.⁵: **H01L 23/08, H01L 23/10**

(30) Priority: 31.05.90 JP 142368/90

(43) Date of publication of application:
04.12.91 Bulletin 91/49

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Wakabayashi, Tetsushi**

4-15-1-114, Chigasakiminami, Kouhoku-ku
Yokohama-shi, Kanagawa, 223(JP)
Inventor: **Kubota, Yoshihiro**
5-8-2-A, Shukugawara, Tama-ku
Kawasaki-shi, Kanagawa-ken 214(JP)

(74) Representative: **Schmidt-Evers, Jürgen,**
**Dipl.-Ing. et al**
**Patentanwälte Mitscherlich & Partner,**
**Steinsdorfstrasse 10**
**W-8000 München 22(DE)**

(54) Semiconductor package having improved mechanical stability for holding interconnection leads and improved capability of hermetic sealing.

(57) A semiconductor device comprises a semiconductor chip (12), a package base (11) for holding the semiconductor chip (12), a solder glass layer (13a, 13b) provided on a rim area (11b) of the package base to surround the semiconductor chip, a first, outer region (13a) of a vitreous glass and a second, inner region (13b) of a devitrifiable glass, formed in the solder glass layer to surround the semiconductor chip, a plurality of interconnection leads (14) provided on the solder glass layer for external connection such that each lead is fixed on the first and second regions, a package lid (15) provided on the package base to form a space (17) between the package base and the package lid for accommodating the semiconductor chip, and a layer of a vitreous glass (16) provided on the package lid in correspondence to the rim area of the package base, wherein the package lid is mounted on the package base such that the vitreous glass layer on the rim part of the package lid makes an intimate contact with the first and second regions sealing the space hermetically.

FIG.3

## BACKGROUND OF THE INVENTION

The present invention generally relates to semiconductor devices, and in particular to a semiconductor package structure that provides an improved mechanical stability for supporting interconnection leads and improved capability of hermetic sealing.

Ceramic packages are used for holding a semiconductor chip together with a number of leads on a ceramic base to construct a semiconductor device ready for mounting on a circuit board. Typically, the ceramic package has a structure in which a semiconductor chip is bonded on a ceramic base by a braze such as Au, Al-Si alloy, silver glass or a conductive resin. Further, a number of leads are mounted on the ceramic base, and a ceramic lid is provided on the base to protect the semiconductor chip. Conventionally, glasses or devitrifiable glasses are used for mounting the leads on the ceramic base and for mounting the ceramic lid on the base.

In the recently developed large scale integrated circuits such as EPROM or large scale gate arrays, a ceramic package that provides an improved degree of sealing is required. For example, a leakage in the order of $10^{-9}$ atm.cc/sec or less is required when tested at a pressure of 5 kg/cm$^2$ for 40 hours.

It has been known that an excellent hermetic seal is achieved when a glass solder of a vitreous glass is employed for mounting the leads on the ceramic base. On the other hand, such a solder glass, having a low softening point, has a problem of mechanical instability in supporting the interconnection leads on the package base. In view point of the mechanical stability, the devitrifiable glasses are preferred, as the devitrifiable glass provides a rigid support for leads mounted on the ceramic base. On the other hand, the devitrifiable glass has a problem in that the sealing of the obtained semiconductor package tends to become unsatisfactory.

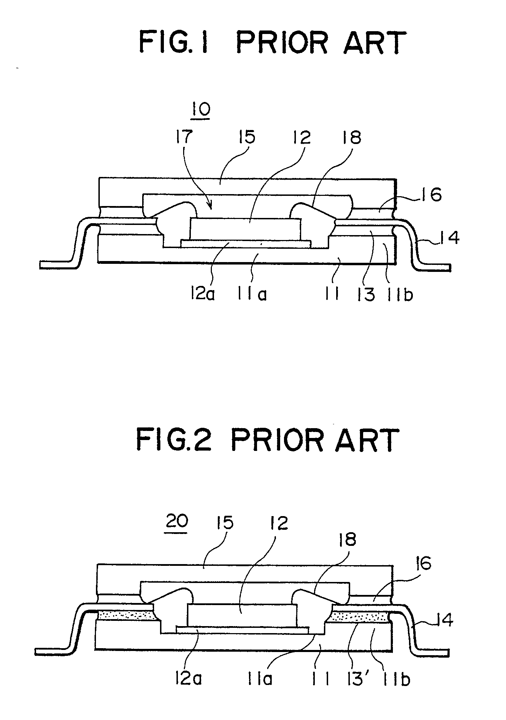

FIGS.1 and 2 show the structure of conventional ceramic packages, wherein the structure of FIG.1 shows the case in which a solder glass is used for mounting the lead while FIG.2 shows the case in which a devitrifiable glass is used for mounding the lead.

Referring to FIG.1, the ceramic package shown as a package 10 comprises a ceramic base 11 formed with a depression 11a at a central part thereof, and a semiconductor chip 12 is mounted on the depression 11a by a layer of braze 12a, which may be made of gold, a Si-Al alloy, silver glass or a conductive resin.

On an elevated rim part 11b formed in the ceramic base 11 to surround the depression 11a, a layer 13 of a vitreous glass is provided as a solder glass, and a lead 14 is provided on the rim part 11b via the vitreous glass layer 13. Further, a ceramic lid 15 is mounded on the ceramic base 11 and fixed on the lead 14 by another vitreous glass layer 16. Thereby, a hermetically sealed space 17 is formed between the ceramic base 11 and the ceramic lid 15 by the vitreous glass layers 13 and 16 that are fused with each other. In the space 17, the semiconductor chip 12 is connected to the leads 14 via bonding wires 18.

In this structure, an amorphous, vitreous glass is used for the layers 13 and 16. In such a structure, although an excellent hermetic seal can be achieved, there arises an obvious problem in that the vitreous glass layer 13 tends to be deformed at the time of sealing the space 17 by the ceramic lid 15. It should be noted that such a process of sealing includes an annealing process of the assembly of the ceramic base 11 and the lid 15 in a furnace, with the semiconductor chip 12 and the lead 14s mounted in the state as illustrated in FIG.1. The annealing is achieved at 380 - 480 °C and because of this, there is a substantial risk that the solder glass layer 13 supporting the lead 14 is deformed. When such a deformation occurs, the mounting of the lead 14 becomes non-uniform and the assembling of the semiconductor device on the circuit board becomes difficult. In the extreme case, the packaged device has to be rejected.

In the structure of FIG.2, on the other hand, a solder glass layer 13' of devitrifiable glass such as the Corning #7583 is used in place of the vitreous glass layer 13. In FIG.2, the parts that correspond to the parts described previously are designated by the same reference numerals and the description thereof will be omitted.

As the glass ceramics maintain the high viscosity at high temperatures, the structure of FIG.2 provides a rigid support of the lead 14 even when the ceramic base 11 is passed through a furnace with the ceramic lid 15 mounted thereon. Thereby, the problem of deformation of the layer 13' and associated displacement of the lead 14 supported thereon is avoided.

In the structure of FIG.2, however, there arises a problem in that the surface of the layer 13' not covered by the lead 14, tends to become irregular or rough because of the consumption of oxygen at the time of crystallization of the glass. In order to explain this phenomenon, the process for forming the structure of FIG.2 will be reviewed briefly.

First, a mixture comprising the starting material of the devitrifiable glass and an organic binder is applied on the elevated rim part 11b of the ceramic base 11, and the ceramic base 11 is subjected to a glazing process that is generally achieved at a temperature of 200 - 300 °C for removing the organic solvents. In the latest stage of the glazing, the temperature is raised to about 400 °C and cooled subsequently. Next, the lead 14 is mounted on the elevated rim part 11b at 400 - 500 °C, and the crystallization of the glass is carried out by annealing the ceramic base 11 together with the leads 14 at 400 - 500 °C for several tens of minutes. During the this process, oxygen is needed for the crystallization of the glass, and because of this reason, oxygen is incorporated into the glass through the exposed upper surface thereof not covered by the leads 14. In the devitrifiable glass, precipitates such as $4PbO \cdot B_2O_3$, $2PbO \cdot ZnO \cdot B_2O_3$ and the like, are formed when the Corning #7583 glass is used. Because of the incorporation of oxygen, the surface of the glass ceramic layer 13' tends to become irregular or rough except for those parts that are covered by the leads 14. The formation of such a rough surface is particularly conspicuous at the surface region of the layer 13'. After the crystallization process, the semiconductor chip 12 is mounted, the bonding wires 18 provided, and the lid 15 is attached to the ceramic base 11 and bonded thereto by melting the layer 16 of vitreous glass at 380 - 480 °C. Obviously, the devitrifiable glass layer 13' provides a mechanically rigid support against the leads 14 at the time of mounting the lid 15, and the problem of the displacement of the leads 14 is avoided.

On the other hand, such a structure has a problem in that the vitreous glass layer 16 on the lid 15 does not cause the fusion with the corresponding devitrifiable glass layer 13' because of the elevated melting temperature of the devitrifiable glass. Further, because of the rough surface of the devitrifiable glass layer 13' in correspondence to where the layer 13' makes a direct contact with the vitreous glass 16, there is a tendency that the leakage occurs along the boundary between the layer 13' and the layer 16. The experiments conducted on the structure of FIG.2 shows the existence of minute leakage, indicating that the glass layer 16 does not make intimate contact with the rough surface of the layer 13'. Although the rate of leakage is in the order of $10^8$ atom $\cdot$ cc/sec in the test conducted at 5 kg/cm$^2$ for 4 hours in the conventional device, a smaller leakage rate in the order of $10^{-9}$ atm $\cdot$ cc/sec or less is required in the recently developed semiconductor devices that have the increased integration density, under even more stringent environment such as 5 kg/cm$^2$ for 40 hours.

## SUMMARY OF THE INVENTION

Accordingly, it is a general object of the present invention to provide a novel and useful semiconductor package structure, wherein the foregoing problems are eliminated.

Another and more specific object of the present invention is to provide a semiconductor package structure that provides a rigid mechanical support against the leads mounted thereon, particularly at the time of hermetic sealing process for sealing the ceramic package by a ceramic lid, and also is capable of providing an improved hermetic sealing.

Another object of the present invention is to provide a semiconductor package structure comprising a ceramic package base formed with a depression that is surrounded by an elevated rim part, a semiconductor chip attached to the depression, a solder glass layer provided on the elevated rim part, a plurality of interconnection leads attached on the elevated rim part by the solder glass layer, and a ceramic lid for covering the semiconductor chip, the ceramic lid having a rim part provided with a vitreous glass for sealing the semiconductor chip, said solder glass layer comprising an outer part and an inner part, wherein one of said outer part and inner part comprises a glass ceramic and the other of said outer part and inner part comprises a vitreous glass. According to the present invention, an improved mechanical stability is achieved by using the glass ceramic for supporting the interconnection leads while still maintaining an excellent hermetic sealing of the package by employing the vitreous glass in a part of the solder glass layer for causing a fusion with the vitreous glass on the package lid.

Other objects and further features of the present invention will become apparent from the following detailed description when read in conjunction with the attached drawings.

## BRIEF DESCRIPTION OF THE DRAWINGS

FIG.1 is a diagram showing the elevational cross section of a conventional ceramic package that uses a vitreous glass for the hermetic sealing of the package and also for the mechanical supporting of interconnection leads;

FIG.2 is a diagram showing the elevational cross section of another conventional ceramic package that uses a glass ceramic for the mechanical supporting of the interconnection leads;

FIG.3 is a diagram showing the elevational cross section of the ceramic package according to a first embodiment of the present invention;

FIG.4 is a diagram showing the plan view of the ceramic package of FIG.3;

FIG.5 is a diagram showing the cross section similar to FIG.3 but taken along a section to avoid the interconnection leads;

FIG.6 is a diagram showing a modification of the present invention;

FIG.7 is a diagram showing the elevational cross section of the ceramic package according to a second embodiment of the present invention;

FIG.8 is a diagram showing the plan view of the ceramic package of FIG.7;

FIG.9 is a diagram showing the elevational cross section of the ceramic package according to a third embodiment of the present invention;

FIG.10 is a diagram showing the elevational cross section of the ceramic package according to a fourth embodiment of the present invention;

FIG.11 is a diagram showing the cross section of the ceramic package of FIG.10 taken perpendicular to the cross sectional view of FIG.10; and

FIG.12 is a diagram showing the plan view of the ceramic package of FIG.10.

DETAILED DESCRIPTION

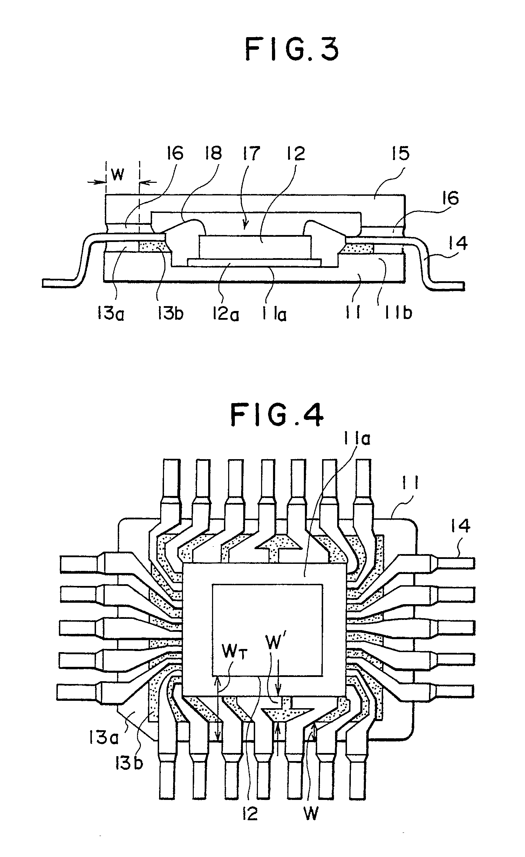

FIG.3 shows a first embodiment of the present invention. In FIG.3, the parts that correspond to the parts described previously with reference to the preceding drawings are designated by the same reference numerals and the description will be omitted.

In the structure of FIG.3, the solder glass layer 13 of FIG.1 is replaced with a structure including a first region 13a and a second region 13b, wherein the first region 13a is formed of a vitreous glass and extends on the elevated rim part 11b of the ceramic package base 11 along the outer periphery thereof, while the second region 13b is formed of a devitrifiable glass and extends on the elevated rim part 11b along the inner periphery thereof. See the plan view of FIG.4. There, the interconnection leads 14 are fixed on the rim part 11b by the devitrifiable glass region 13b and further by the vitreous glass region 13a, and because of this, a rigid mechanical support is provided against the interconnection leads 14 by the devitrifiable glass region 13b at the time of sealing the package by the lid 15.

In forming the structure of FIG.3, the starting materials for the vitreous glass and the glass ceramic are screen printed respectively in correspondence to the regions 13a and 13b with a thickness of 0.20 - 0.30 mm. In the plan view of FIG.4, the critical width $W_T$ of the rim part 11b is set to 1.5 - 2.5 mm, while the width W of the region 13a and the width W' of the region 13b are set to about 1/2 of the width $W_T$. After removing the organic binders at 200 - 300 $^\circ$C, the glazing process at 400 - 430 $^\circ$C is carried out for 3 - 5 minutes, and the nucleation of the initially crystallized phase occurs in the region 13b. The interconnection leads 14 having the thickness of about 0.15 mm are then attached to the glazed surface of the regions 13a and 13b at a temperature of about 400 - 450 $^\circ$C for 10 - 20 minutes in the form of a lead frame.

After cooling to the room temperature, the leads are separated from each other by cutting the tieber of the lead frame and bent downward as shown in FIG.3 for mounting on the circuit board. As the devitrifiable glass forming the region 13b, a product marketed from Corning Glass Works under the trade name #7583 may be employed, while as the vitreous glass for the region 13a, a product with the trade name IWF-T187 available from the Iwaki Glass, Ltd may be employed. It should be noted that, until to the present step, the crystallization of the devitrifiable glass has not yet occurred.

Next, the structure thus obtained is subjected to a thermal annealing process at 400 - 4550 $^\circ$C for about 1 hour, and the crystallization is started in the region 13b. Thereby, the crystals precipitate in the region 13b and the devitrifiable glass having an increased melting point is formed. Simultaneously, the minute cracks formed in the regions 13a and 13b at the time of bending the leads 14 are cured by the thermal annealing process.

It should be noted that, during this crystallization process, the surface of the devitrifiable glass region 13b becomes rough because of the consumption of oxygen associated with the crystallization except for the part covered by the leads 14. In the vitreous glass region 13a, no such rough surface appears. Thus, in FIG.4, the rough surface formed as a result of the crystallization is indicated by the matte pattern.

In the structure thus obtained, the semiconductor chip 12 is attached as usual, for example by the gold or Si-Al braze layer 12a, silver glass or by using a conductive resin, and the electric connection between the bonding pad region (not shown) and the corresponding lead 14 is established by the bonding wire 18.

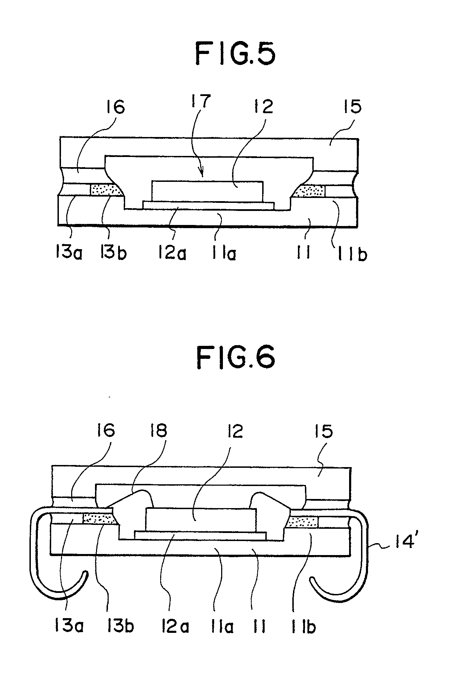

Next, the ceramic lid 15 carrying the vitreous glass 16 at the outer periphery thereof is placed on the ceramic package base 11 such that the vitreous glass 16 contacts with the elevated rim part 11b of the package base 11 at a part including at least the vitreous glass region 13a. In this state, the ceramic package is annealed at a temperature between 430 $^\circ$C - 480 $^\circ$C for 8 - 10 minutes. Thereby, the vitreous glass regions 13a and 16 cause a fusion with each other as shown in FIG.5 and the space 17 formed in the package for accommodating the semiconductor chip 12 is sealed hermetically. Preferably, the vitreous glass 16 makes a contact with the entire surface of the regions 13a and 13b. It should be noted that FIG.5 shows the cross section of FIG.4 along a line avoiding the lead 14. As the structure of FIG.5 is obvious from FIGS.3 and 4, the description thereof will be omitted.

During this process, it should be noted that, because of the increased melting point and thus the increased viscosity, the devitrifiable glass region 13b experiences little deformation and the interconnection leads 14 held thereon are supported with rigidity. Thereby, the displacement of the leads 14 does not occur while still maintaining an excellent hermetic sealing of the space 17 by the fusion of the vitreous glass regions 16 and 13a.

After the sealing, the package thus produced is subjected to an electrolytic etching process wherein the oxides formed on the surface of the leads 14 are removed. Typically, a mixture of nitric acid and sulfuric acid is used for the etching solution. Further, the leads 14 are applied with a tin or solder plating.

The ceramic package of the present invention, having the vitreous glass region 13a at the outer side of the glass ceramic region 13b, is particularly advantageous for the hermetic seal of the package, as the effective length of the seal is given by the sum of the width W of the region 13a and the width W' of the region 13b, provided that the vitreous glass of the region 16 of the ceramic lid 15 covers the entire surface of the regions 13a and 13b, including the leads 14. The advantage associated with this point will become clear in comparison with the second embodiment of the present invention to be described later. The ceramic package of the present embodiment is capable of exhibiting the reduced leakage rate in the order of $10^{-9}$ atm·cc/sec or less and is suited for use in the large scale integrated circuits such as recent large capacity EPROMs and large scale gate arrays.

From the practical reason of the screen-printing process, the width W, defined on the elevated rim part 11b (FIG.3) as a region where the low melting glass region 13a and the low melting glass region 16 form an overlap, is preferably set to be about 0.5 mm or more.

FIG.6 shows a modification of the first embodiment, wherein the leads 14 are bent to form a J-shape. The construction of the present invention of using the devitrifiable glass region 13b adjacent to the vitreous glass is particularly advantageous in the device of FIG.6, wherein a large stress is applied to the devitrifiable glass region 13b that is likely to cause the displacement of the leads 14' when the regions 13a and 13b are both formed of the vitreous glass.

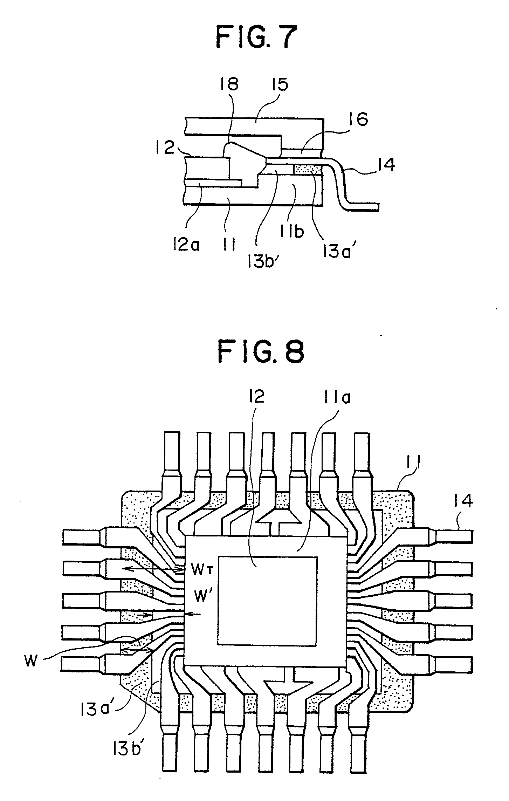

FIGS.7 and 8 show a second embodiment of the present invention, wherein the vitreous glass region 13a of the first embodiment is replaced with a devitrifiable glass region 13a' and the devitrifiable glass region 13b is replaced with a vitreous glass region 13b'.

Theoretically, this structure is expected to show the desired mechanical stability of the leads 14 and at the same time the desired reduction of the leakage. In fact, the structure of this embodiment does show a superior performance as compared to the conventional package structures shown in FIGS.2 and 3 with respect to the mechanical stability of the leads and the reduced leakage. On the other hand, this structure of FIG.8 is less effective in reducing the leakage as compared to the first embodiment, as the sealing given by the devitrifiable glass region 13a' is not effective in this structure. The effective length of the seal is reduced from $W_T$ for the first embodiment to W'.

This deterioration in the effect of sealing is believed to be caused by the leakage occurring along the rough surface of the glass ceramic region 13a' located at the outer side of the region 13b'. It has been observed, in the conventional structure of FIG.2, that the leakage starts to occur when the package is subjected to the etching process for removing the oxides from the leads 14. Before that process, the leakage is not observed even when the devitrifiable glass is used for the region 13. From the foregoing observation, it is believed that there is formed an extremely thin glass region (not shown) along the outermost edge of the rim 11b at the time when the ceramic package is sealed by the lid 15 even when the devitrifiable glass layer 13' is used, and this thin glass region prevents the penetration of the external atmosphere into the sealed space 17. When the package is subjected to the etching process for removing the oxides from the surface of the leads 14, this thin glass region is removed and the penetration of the surrounding atmosphere into the package starts to occur.

From this view point, the structure of FIG.4 has an obvious advantage, as the devitrifiable glass region 13b is located at the inner side of the vitreous glass region 13a and does not contact to the etching solution. As the vitreous glass region 13a forms an intimate contact with the corresponding vitreous glass region 16 of the lid 15 by causing the fusion, the etching process does not affect on the quality of sealing. Thereby, the entire width $W_T$ can be used for sealing the space 17.

On the other hand, in the structure of FIG.8, the desired sealing is not achieved in the region 13a' because of the same reason as the package of FIG.2 that the thin glass region sealing the package at the outer periphery of the rim part 11b is removed at the time of etching. In the absence of the sealing effect in the region 13a', the foregoing problem of reduced effective seal length is inevitable. It should be noted that the process of etching for removing the oxides from the leads 14 cannot be omitted.

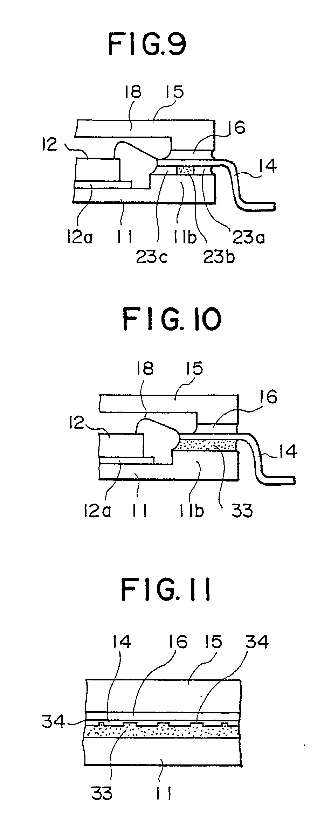

FIG.9 shows a third embodiment of the present invention, wherein there are three glass regions on the elevated rim part 11b of the package base 11. Thus, there is formed a vitreous glass region 23a along the outer periphery of the rim part 11b, a glass ceramic region 23b formed along the region 23a at an inner side thereof, and a vitreous glass region 23c formed at a further inner side of the glass ceramic region 23b along the inner periphery of the rim part 11b. Thereby, a rigid support of the leads 14 is obtained by the devitrifiable glass region 23b while maintaining an excellent sealing provided by the vitreous glass regions 23a and 23c. As other structural features are common with the first and second embodiments, further description thereof will be omitted.

FIGS.10 and 11 show a fourth embodiment of the present invention. In these drawings, those parts that are constructed identically with the parts described in the previous embodiments are designated by the same reference numerals and the description thereof will be omitted.

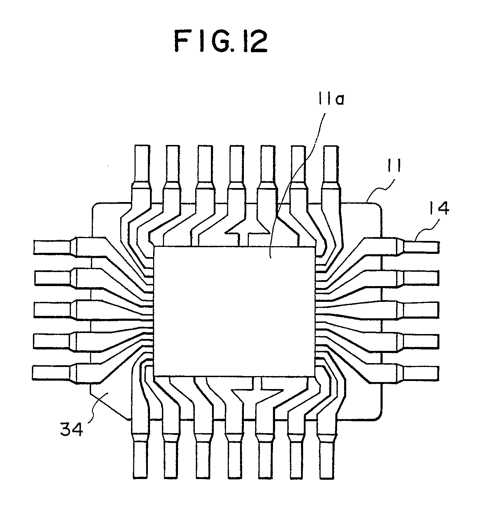

In the present embodiment, a devitrifiable glass layer 33 is provided to cover the entire surface of the elevated rim part 11b of the ceramic package body 11, and the interconnection leads 14 are provided on the glass ceramic layer 33. Further, a vitreous glass 34 is used to fill the gap region formed on the devitrifiable glass layer 33 between the adjacent leads 14. Thereby, the package base 11 shows explicitly the surface of vitreous glass at the elevated rim part 11b in the plan view as shown in FIG.12. Thus, an excellent sealing can be achieved in the package of FIG.12 when the ceramic lid 15 is provided.

In forming the structure of FIGS.10 - 12, the low melting glass is provided on the glass ceramic layer 33 in correspondence to the gap region 34 between the adjacent leads 14. It should be noted that this formation of the vitreous glass region 34 is made after the formation of an amorphous precursor or glaze of the glass ceramic layer 33 on the rim part 11b and the subsequent attachment of the leads 14 thereon. Further, it should be noted that this formation of the vitreous glass region 34 is made before the crystallization of the glaze is achieved.

Next, the structure thus obtained is annealed to cause the crystallization in the devitrifiable glass layer. As the surface of the glass ceramic layer 33 is already covered either by the vitreous glass or the interconnection leads 14, the top surface of the devitrifiable glass layer 33 is maintained smooth, establishing an intimate contact with the lower surface of the vitreous glass region 34 or the lower surface of the leads 14. Thus, the problem of poor sealing caused by the rough surface of the devitrifiable glass layer 33 is eliminated.

After the crystallization of the devitrifiable glass layer 33, the semiconductor chip 12 is mounted, the bonding wires 19 attached, and the cover lid 15 is mounted while causing the melting in the vitreous glass regions 16 and 34. Thereby, a rigid mechanical support is given to the leads 14 by the devitrifiable glass layer 33 while maintaining excellent sealing.

Further, the present invention is not limited to the embodiments described heretofore, but various variations and modifications may be made without departing from the scope of the invention.

## Claims

1. A semiconductor device, comprising: a semiconductor chip (12); a package base (11) for holding the semiconductor chip, said package base having a chip area (11a) for supporting the semiconductor chip thereon and a rim area (11b) having an upper major surface and surrounding the chip area without interruption, said rim area having an outer boundary and an inner boundary extending such that the inner boundary is located closer to the semiconductor chip than the outer boundary; a solder glass layer (13a, 13b) having upper and lower major surfaces and provided on the upper major surface of the rim area without interruption; a plurality of interconnection leads (14) provided on the upper major surface of the solder glass layer for external connection of the semiconductor device such that each of the leads is fixed on the rim area by the solder glass layer; a plurality of bonding wires (18) connecting the semiconductor chip to the plurality of leads; a package lid (15) provided on the package base, said package lid having a rim part along an outer periphery thereof in correspondence to the rim area of the package base, said rim part having a lower major surface facing the upper major surface of the rim area of the package base when the package lid is mounted on the package base; and a layer of a vitreous glass (16) having upper and lower major surfaces and provided on the lower major surface of the rim part of the package lid; characterized in that: said solder glass layer at least comprises a first region (13a) having upper and lower major surfaces respectively coincident to the upper and lower major surfaces of the solder glass layer, said first region having an outer boundary and an inner boundary such that said inner boundary is located closer to the semiconductor chip than the outer boundary, and a second region (13b) having upper and lower major surfaces respectively coincident to the upper and lower major surfaces of the solder glass layer and having an outer boundary and an inner boundary such that said inner boundary of the second region is located closer to the semiconductor chip than the outer boundary of the second region, said second region being disposed at a side of the first region closer to the semiconductor chip, one of said first and second regions comprising a low-viscosity glass having a first viscosity and the other of said first and second regions comprising a high-viscosity glass having a second viscosity that is higher than the first viscosity;

each of said plurality of leads extends on the upper major surface of the solder glass layer at least in correspondence to the respective upper major surfaces of the first and second regions; and

said package lid is mounted on the package base such that said lower major surface of the vitreous glass layer on the rim part of the package lid makes an intimate contact with at least the upper major surface of one of the first and second regions that comprises the low-viscosity glass for sealing the space hermetically and such that the vitreous glass layer buries the interconnection leads therein.

2. A semiconductor device as claimed in claim 1 characterized in that said first region (13a) comprises a vitreous glass and said second region (13b) comprises a devitrifiable glass.

3. A semiconductor device as claimed in claim 1 characterized in that said first region (13a) comprises a devitrifiable glass and said second region (13b) comprises a vitreous glass.

4. A semiconductor device as claimed in claim 1 characterized in that said lower major surface of the vitreous glass (16) on the rim part of the package lid (15) contacts with both of the upper major surfaces of the first and second regions.

5. A semiconductor device as claimed in claim 1 characterized in that said lower major surface of the vitreous glass (16) on the rim part of the package lid (15) contacts with the entire upper major surface of the solder glass layer (13a, 13b).

6. A semiconductor device as claimed in claim 2 characterized in that said solder glass layer (13a, 13b) further comprises a third region (13c) having an upper major surface coincident to the upper major surface of the solder glass layer and a lower major surface coincident to the lower major surface of the solder glass layer, said third region comprising a low melting glass.

7. A semiconductor device, comprising: a semiconductor chip (12); a package base (11) for holding the semiconductor chip, said package base having a chip area (11a) for supporting the semiconductor chip thereon and a rim area (11b) having an upper major surface and surrounding the chip area without interruption; said rim area having an outer boundary and an inner boundary extending such that the inner boundary is located closer to the semiconductor chip than the outer boundary; a solder glass layer of a glass ceramic (33) having upper and lower major surfaces and provided on the upper major surface of the rim area without interruption; a plurality of interconnection leads (14) provided on the upper major surface of the solder glass layer for external connection of the semiconductor device such that each of the leads is fixed on the rim area by the solder glass layer with a gap formed there-between; a plurality of bonding wires (18) connecting the semiconductor chip to the plurality of interconnection leads; a package lid (15) provided on the package base, said package lid having a rim part along an outer periphery thereof in correspondence to the rim area of the package base, said rim part having a lower major surface facing the upper major surface of the rim area of the package base when the package lid is mounted on the package base; and a layer of a vitreous glass (16) having upper and lower major surfaces and provided on the lower major surface of the rim part of the package lid;

characterized in that there is provided a filler region (34) of a vitreous glass having an upper major surface and a lower major surface, said filler region being provided on the upper major surface of the solder glass layer to fill the gap;

said package lid being mounted on the package base such that said lower major surface of the vitreous glass layer on the rim part of the package lid makes an intimate contact with the upper major surface of the filler region for sealing the space hermetically and such that the vitreous glass layer buries the interconnection leads therein.

8. A method for producing a semiconductor device accommodated in a package, characterized by the steps of:

providing a region (13a) of a vitreous glass (13b) and a region of a precursor material of a devitrifiable glass on a rim area (11b) of a package base forming a part of the package base to surround a chip area (11a) that is defined on the package base (11) for supporting a semiconductor chip (12);

attaching a plurality of interconnection leads (14) on the rim area of the package base such that each of interconnection leads extends on both of the regions of the vitreous glass and the precursor material with a contact thereto;

crystallizing the precursor material to form a devitrifiable glass in correspondence to the region of the precursor;

attaching a semiconductor chip (12) on the chip area (12a);

connecting the semiconductor chip to the leads by bonding wires (18);

attaching a package lid (15) having a region of a vitreous glass (16) in correspondence to an outer periphery thereof and forming a part of the package, such that the region of vitreous glass on the package lid contacts with the region of the low melting glass and the region of the glass ceramic both formed on the package base; and

melting the vitreous glass region of the package lid and the vitreous glass region of the package base to seal the semiconductor chip (12) in a space (27) formed between the package base and the package lid.

9. A method for producing a semiconductor device having package, characterized by the steps of:

providing a region of a precursor of a glass ceramic (33) on a rim area (11b) of a package base (11) forming a part of the package to surround a chip area (11a) that is defined in the package base for supporting a semiconductor chip (12);

attaching a plurality of interconnection leads (14) on the region of the precursor with a gap formed between the interconnection leads;

providing a plurality of regions (34) of a vitreous glass on the region of the precursor to fill the gap formed between the interconnection leads;

crystallizing the precursor (33) to form a devitrifiable glass in correspondence to the rim area (11b) of the package base;

attaching a semiconductor chip (12) on the chip area on the package base;

connecting the semiconductor chip to the plurality of interconnection leads by a plurality of interconnection wires (18);

attaching a package lid (15) having a region of a vitreous glass in correspondence to an outer periphery thereof and forming a part of the package, such that the region of vitreous glass on the package lid contacts with the region of the low melting glass filling the gap;

and

melting the vitreous glass region of the package lid and the vitreous glass region of the package base to seal the semiconductor chip in a space formed between the package base and the package lid.

# FIG.1 PRIOR ART

# FIG.2 PRIOR ART

# FIG.3

# FIG.4

# FIG.5

16    17    12    15

13a    13b    12a    11a    11    11b

# FIG.6

16    18    12    15

14'

13a    13b    12a    11a    11    11b

# FIG. 7

# FIG. 8

# FIG.9

# FIG.10

# FIG.11

# FIG. 12